(19) **Europäisches Patentamt / European Patent Office / Office européen des brevets**

(11) **EP 4 559 059 B1**

(12) **FASCICULE DE BREVET EUROPEEN**

(45) Date de publication et mention de la délivrance du brevet:
**18.03.2026 Bulletin 2026/12**

(21) Numéro de dépôt: **23764681.5**

(22) Date de dépôt: **13.07.2023**

(51) Classification Internationale des Brevets (IPC):
**H01S 3/09** *(2006.01)* **H01S 3/00** *(2006.01)*
**H01S 3/02** *(2006.01)* **H01S 3/08** *(2023.01)*

(52) Classification Coopérative des Brevets (CPC):
**H01S 3/0903; H01S 3/0071; H01S 3/02;**
H01S 3/005; H01S 3/08009; H01S 2302/02

(86) Numéro de dépôt international:
**PCT/FR2023/051089**

(87) Numéro de publication internationale:
**WO 2024/018139 (25.01.2024 Gazette 2024/04)**

(54) **DISPOSITIF ET PROCEDE DE GENERATION D'UN RAYONNEMENT TERAHERTZ COHERENT**

VORRICHTUNG UND VERFAHREN ZUR ERZEUGUNG KOHÄRENTER TERAHERTZSTRAHLUNG

DEVICE AND METHOD FOR GENERATING COHERENT TERAHERTZ RADIATION

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **22.07.2022 FR 2207571**

(43) Date de publication de la demande:
**28.05.2025 Bulletin 2025/22**

(73) Titulaire: **Commissariat à l'Energie Atomique et aux Energies Alternatives**
**75015 Paris (FR)**

(72) Inventeurs:
- **GOEURY, Alexandre**
  **33116 Le Barp Cedex (FR)**
- **GARDELLE, Jacques**
  **33116 Le Barp Cedex (FR)**
- **CASSANY, Bruno**
  **33116 Le Barp Cedex (FR)**

(74) Mandataire: **Santarelli**
**Tour Trinity**
**1 bis Place de la Défense**
**92400 Courbevoie (FR)**

(56) Documents cités:
**FR-A1- 3 004 294     US-A1- 2006 062 258**

- **GARDELLE J ET AL: "Observation of copious emission at the fundamental frequency by a Smith-Purcell free-electron laser with sidewalls", APPLIED PHYSICS LETTERS, AMERICAN INSTITUTE OF PHYSICS, 2 HUNTINGTON QUADRANGLE, MELVILLE, NY 11747, vol. 100, no. 13, 26 March 2012 (2012-03-26), pages 131103 - 131103, XP012155352, ISSN: 0003-6951, [retrieved on 20120326], DOI: 10.1063/1.3696381**
- **J. T. DONOHUE ET AL: "Simulation of a Smith-Purcell free-electron laser with sidewalls: Copious emission at the fundamental frequency", APPLIED PHYSICS LETTERS, vol. 99, no. 16, 19 October 2011 (2011-10-19), pages 161112, XP055025666, ISSN: 0003-6951, DOI: 10.1063/1.3641471**
- **DONOHUE J T: "INTENSE EMISSION OF SMITH-PURCELL RADIATION AT THE FUNDAMENTAL FREQUENCY FROM A GRATING EQUIPPED WITH SIDEWALLS", 2013, XP093025453, Retrieved from the Internet <URL:https://accelconf.web.cern.ch/FEL2013/papers/weobno03.pdf> [retrieved on 20230220]**
- **GARDELLE J. ET AL: "Observation of coherent Smith-Purcell radiation using an initially continuous flat beam", PHYSICAL REVIEW SPECIAL TOPICS - ACCELERATORS AND BEAMS, vol. 12, no. 11, 9 November 2009 (2009-11-09), XP093023399, DOI: 10.1103/PhysRevSTAB.12.110701**

- **GARDELLE JACQUES ET AL: "Radiation at 100 and 200 GHz From a Compact Planar Smith-Purcell Free-Electron Laser", IEEE TRANSACTIONS ON TERAHERTZ SCIENCE AND TECHNOLOGY, IEEE, PISCATAWAY, NJ, USA, vol. 7, no. 2, March 2017 (2017-03-01), pages 151 - 163, XP011642230, ISSN: 2156-342X, [retrieved on 20170303], DOI: 10.1109/TTHZ.2017.2653619**

- **PRICE E J ET AL: "SHORT SUBMILLIMETER OPERATION OF THE PLANAR OROTRON", NUCLEAR INSTRUMENTS & METHODS IN PHYSICS RESEARCH. SECTION A, ELSEVIER BV * NORTH-HOLLAND, NL, vol. A304, no. 1 / 03, July 1991 (1991-07-01), pages 133 - 136, XP000238552, ISSN: 0168-9002, DOI: 10.1016/0168-9002(91)90835-E**

**Description**

## DOMAINE TECHNIQUE

La présente invention concerne le domaine des sources électromagnétiques cohérentes dans le domaine du térahertz THz, en particulier des générateurs de rayonnement Smith-Purcell cohérent.

## ÉTAT DE LA TECHNIQUE ANTÉRIEURE

Actuellement, il existe deux technologies de sources électromagnétiques cohérentes dans le domaine THz.

Une première technologie concerne des équipements générant des rayonnements électromagnétiques à haute fréquence par résonance stimulée d'électrons libres se déplaçant à travers un champ magnétique puissant. Ces équipements peuvent en général, délivrer des puissances supérieures au Watt sous une fréquence de 1 THz mais sont relativement onéreux et peu compacts. Le Gyrotron est un équipement de ce genre de technologie qui nécessite de très forts champs magnétiques, produits par des aimants supraconducteurs insérés dans des cryostats. Cet équipement très onéreux et volumineux peut délivrer une très forte puissance de l'ordre du kW en continu mais à une seule fréquence.

Une deuxième technologie concerne les lasers à cascade quantique (QCLs) relativement compacts pouvant générer une fréquence de 1 THz mais avec une puissance émise qui n'excède pas le mW. De plus, ces sources lasers ne sont pas accordables c'est-à-dire qu'il est nécessaire de changer la source laser pour changer de fréquence.

Il existe dans l'art antérieur, des dispositifs relativement compacts ,qui peuvent délivrer des rayonnements THz de forte puissance. Ce genre de dispositif exploite les propriétés en trois dimensions d'un réseau de diffraction pour générer un rayonnement Smith-Purcell cohérent de grande efficacité. De tels dispositifs ou procédés sont décrits dans l'article de J. T. Donohue et J. Gardelle, « Simulation of a Smith-Purcell free-electron laser with sidewalls : Copious emission at the fondamental frequency », AppliedPhysics Letters 99 (2011), 161112-1,

l'article de Gardelle J ET AL: "Observation of copious emission at the fundamental frequency by a Smith-Purcell free-electron laser with sidewalls", APPLIED PHYSICS LETTERS, vol. 100, no. 13, 26 mars 2012, pages 131103-131103, l'article de Donohue J T ET AL: "INTENSE EMISSION OF SMITH-PURCELL RADIATION AT THE FUNDAMENTAL FREQUENCY FROM A GRATING EQUIPPED WITH SIDEWALLS", Proceedings of FEL2013, New York, NY, USA, WEOBNO03, pages 477-480, 2013, l'article de Gardelle J ET AL: "Observation of coherent Smith-Purcell radiation using an initially continuous flat beam", PHYSICAL REVIEW SPECIAL TOPICS - ACCELERATORS AND BEAMS, vol. 12, no. 11, 1 novembre 2009, ainsi que dans les brevets français FR 3004294 et FR 2980923.

L'objectif de la présente invention est de proposer un dispositif et un procédé de génération d'un rayonnement Smith-Purcell cohérent, permettant d'améliorer les dispositifs décrits dans les brevets cités ci-dessus en simplifiant encore davantage la mise en œuvre, en diminuant les coûts et en optimisant la compacité.

Un autre objectif de la présente invention est de proposer un dispositif de production de rayonnement Smith-Purcell cohérent accordable, permettant de faire varier la fréquence de rayonnement.

## EXPOSÉ DE L'INVENTION

Cet objectif est atteint avec un dispositif de production de rayonnement électromagnétique Smith-Purcell cohérent comprenant :

- un réseau de diffraction électriquement conducteur, délimité en largeur par deux parois latérales externes électriquement conductrices ;
- une source pour émettre un faisceau d'électrons et le propager au-dessus du réseau de diffraction, le faisceau d'électrons étant configuré pour interagir avec le réseau de diffraction de manière à engendrer un rayonnement électromagnétique de Smith-Purcell cohérent dirigé vers l'amont du réseau de diffraction selon une direction prédéterminée ; et
- un miroir configuré pour récupérer la plus grande partie du rayonnement électromagnétique afin de le rediriger parallèlement au réseau de diffraction vers une sortie en aval du réseau de diffraction.

Ainsi, le dispositif selon l'invention est compact, économique et simple à mettre en œuvre tout en générant un rayonnement électromagnétique cohérent de forte puissance dans la gamme THz.

Avantageusement, le miroir comporte une surface réfléchissante dont la forme géométrique est déterminée sur la base du diagramme de rayonnement du réseau de diffraction en tenant compte des lobes d'émission. La forme du miroir est ainsi optimisée pour renvoyer la puissance émise vers la sortie du dispositif.

Avantageusement, les caractéristiques du faisceau d'électrons comportent :

- une vitesse des électrons suffisamment faible pour que, dans un diagramme de dispersion, où l'on exprime la fréquence en fonction du nombre d'onde, une droite représentant la fréquence du faisceau d'électrons en fonction de son nombre d'onde, et une courbe représentant, dans la première zone de Brillouin, la relation de dispersion en trois dimensions correspondant au mode fondamental du réseau de diffraction, se croisent en un point situé à l'extérieur d'un triangle isocèle dont la base est confondue avec l'axe des abscisses du diagramme de dispersion et dont un côté est un segment de pente $c/2\pi$ passant par l'origine dudit diagramme, où c est la célérité de la lumière dans le vide ; et
- une densité de courant suffisamment élevée pour exciter efficacement le mode fondamental du réseau de diffraction.

On peut ainsi obtenir un rayonnement électromagnétique fortement directionnel et directement issu du mode fondamental d'interaction entre le faisceau d'électrons et le réseau de diffraction.

Avantageusement, le dispositif comporte :

- un tube dont l'axe est parallèle à la propagation du faisceau d'électrons, ledit tube étant connecté à la source sur une extrémité et se termine par un hublot de sortie sur l'autre extrémité, et
- un support disposé à l'intérieur du tube entre la source et le hublot de sortie sur lequel sont fixés de manière amovible le réseau de diffraction et le miroir.

Ainsi, le miroir et/ou le réseau peuvent être remplacés par d'autres miroir et/ou réseau sur le support dans le but de modifier la fréquence d'émission du rayonnement électromagnétique en fonction des paramètres désirés par l'opérateur.

Avantageusement, le support comporte une première partie de surface circulaire perpendiculaire à l'axe du tube et pourvu d'un orifice circulaire pour laisser passer le faisceau d'électrons et une deuxième partie de surface rectangulaire parallèle à l'axe du tube, le miroir étant fixé sur la partie circulaire du support tandis que le réseau de diffraction est fixé sur la partie rectangulaire du support.

Ceci facilite l'extraction du support pour changer le miroir et/ou le réseau.

Avantageusement, le dispositif comporte un élément d'arrêt du faisceau fixé sur la partie rectangulaire du support en aval du réseau de diffraction, ledit élément d'arrêt du faisceau étant destiné à absorber le faisceau en aval du réseau.

Ceci permet d'arrêter le faisceau dès que les électrons ont fini d'interagir avec le réseau.

Avantageusement, l'élément d'arrêt de faisceau présente une forme géométrique configurée pour répartir la densité de courant du faisceau d'électrons sur le maximum de surface tout en laissant passer le rayonnement électromagnétique par le hublot de sortie.

Avantageusement, le tube pourvu de la source et du hublot de sortie forment une enceinte à vide à l'intérieur de laquelle la pression est de l'ordre de $10^{-8}$ mbar à $10^{-7}$ mbar.

Avantageusement, le dispositif comporte des éléments de focalisation et de guidage magnétiques configurés pour focaliser, guider et maintenir le faisceau d'électrons dans une zone située au-dessus du réseau de diffraction.

L'invention porte également sur un procédé de production d'un rayonnement électromagnétique Smith-Purcell cohérent dans lequel :

- on utilise un réseau de diffraction électriquement conducteur, délimité latéralement par deux parois latérales externes électriquement conductrices ;
- on propage un faisceau d'électrons au-dessus du réseau de diffraction, le faisceau d'électrons étant configuré pour interagir avec le réseau de diffraction de manière à engendrer un rayonnement électromagnétique de Smith-Purcell cohérent dirigé vers l'amont du réseau de diffraction selon une direction prédéterminée ; et
- on utilise un miroir configuré pour récupérer l'ensemble du rayonnement électromagnétique et pour le rediriger parallèlement au réseau de diffraction vers une sortie en aval du réseau de diffraction.

## BRÈVE DESCRIPTION DES DESSINS

La présente invention sera mieux comprise à la lecture de la description d'exemples de réalisation donnés à titre purement indicatif et nullement limitatif, en faisant référence aux dessins annexés parmi lesquels :

[Fig. 1A] représente de manière schématique, un dispositif de génération d'un rayonnement électromagnétique, selon un mode de réalisation de l'invention ;

[Fig. 1B] est une vue en perspective schématique d'un réseau de diffraction utilisable dans le dispositif de la Fig. 1A ;

[Fig. 2] illustre un exemple du diagramme de dispersion du réseau de diffraction, selon un mode de réalisation de l'invention ;

[Fig. 3] représente de manière schématique un module de propagation du dispositif illustrant l'interchangeabilité de ses éléments amovibles, selon un mode de réalisation de l'invention ; et

[Fig. 4A]

[Fig. 4B]

[Fig. 4C]

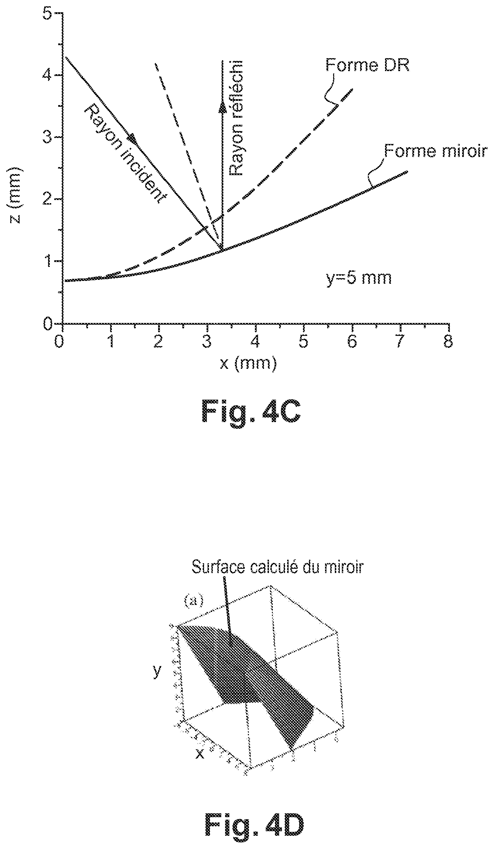

[Fig. 4D] illustrent le dimensionnement du miroir selon le diagramme de rayonnement, selon un mode de réalisation de l'invention.

## EXPOSÉ DÉTAILLÉ DE MODES DE RÉALISATION PARTICULIERS

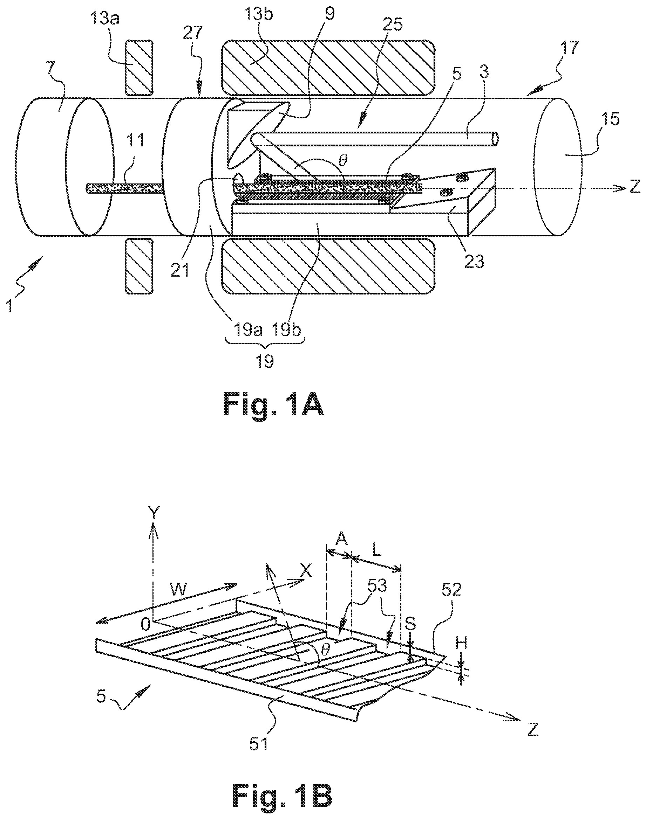

La Fig. 1A, représente de manière schématique, un dispositif de génération d'un rayonnement électromagnétique, selon un mode de réalisation de l'invention. En outre, la Fig. 1B est une vue en perspective schématique d'un réseau de diffraction utilisable dans le dispositif de la Fig. 1A.

Ce dispositif 1 est destiné à engendrer un rayonnement 3 de Smith-Purcell cohérent avec un rendement élevé. Il comporte un réseau de diffraction 5, une source d'électrons 7 et un miroir 9.

Le réseau de diffraction 5 est électriquement conducteur et de préférence amagnétique. Il est délimité latéralement par deux parois 51 et 52 également électriquement conductrices et de préférence amagnétiques.

La source 7 est un canon à électrons (par exemple, un canon thermo-ionique) destiné à produire un faisceau d'électrons 11 qui se propage suivant un axe Z, au-dessus du réseau de diffraction 5, entre les deux parois 51 et 52.

Le faisceau d'électrons 11 est configuré pour interagir avec le réseau de diffraction 5 de manière à produire un rayonnement électromagnétique 3 de Smith-Purcell cohérent.

Le réseau de diffraction 5 présente une série de rainures 53 à profil rectangulaire et parallèles les uns aux autres. On parle alors de réseau de diffraction 5 lamellaire. On pourra également envisager d'autres types de profil, par exemple triangulaire ou sinusoïdal sans sortir du cadre de la présente invention.

L'axe Z, suivant lequel se propage le faisceau d'électrons 11, est perpendiculaire aux sillons 53. Et l'on définit en outre un axe X qui est parallèle aux sillons 53, et donc perpendiculaire à l'axe Z, ainsi qu'un axe Y qui est perpendiculaire aux axes X et Z comme on le voit sur la figure 1B. Les trois axes X, Y et Z se coupent en un point O formant ainsi, un système de coordonnées cartésiennes.

On note W la largeur du réseau de diffraction 5 (i.e. la distance entre ses deux parois latérales 51, 52) et S la hauteur des parois latérales 51, 52. On note A (respectivement H) l'épaisseur (respectivement la profondeur) des rainures 53. On note L la période du réseau de diffraction 5 et l'on note N le nombre de périodes.

De préférence, la largeur W = 2L . La période L est choisie en fonction de la longueur d'onde d'opération de l'application désirée.

On rappelle que, le rayonnement 3 de Smith-Purcell est émis à un angle $\theta$ par rapport à l'axe Z de propagation du faisceau d'électrons, suivant la relation suivante :

[Math 1]

$$\lambda = c / f = L(1/\beta - \cos\theta) / |n| \qquad (1)$$

où $\lambda$ représente la longueur d'onde du rayonnement dans le vide, f la fréquence de ce rayonnement, c la vitesse de la lumière dans le vide, $\beta$ le rapport $v/c$ ($\underline{v}$ : vitesse des électrons) et n l'ordre de diffraction.

La formule (1) suffit à donner l'ordre de grandeur avant un calcul exact des modes du réseau en trois dimensions. La présente invention est en effet fondée sur la théorie des modes en trois dimensions d'un réseau de diffraction 5 de largeur W donnée, équipé de parois latérales 51, 52. A ce sujet, on se reportera aux brevets français FR 3004294 et FR 2980923.

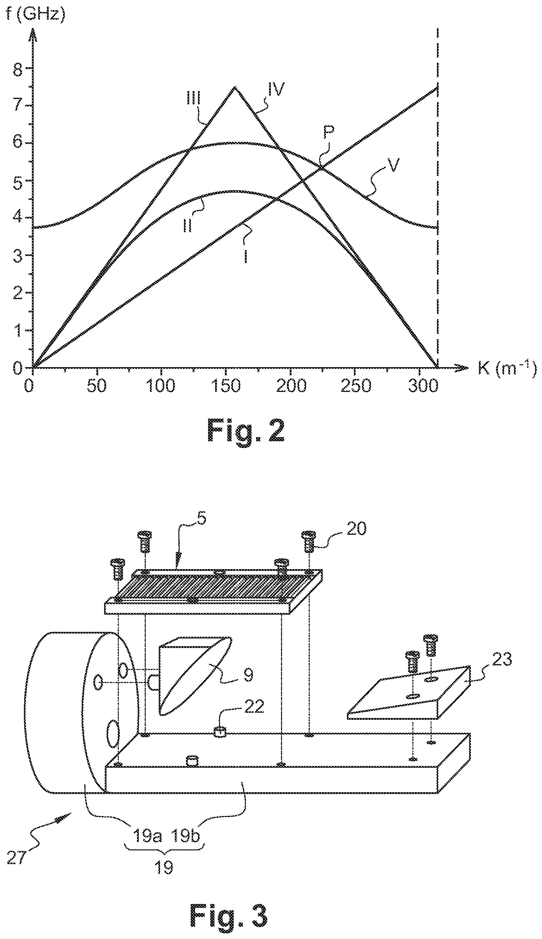

La Figure 2 illustre un exemple de diagramme de dispersion (f, k) du réseau de diffraction, selon un mode de réalisation de l'invention.

Le diagramme de dispersion représente la fréquence du rayonnement f en fonction du nombre d'onde k. On se limite à la première zone de Brillouin, de longueur $2\pi/L$. La droite I, dont l'équation est $f = vk/2\pi$ représente la fréquence du faisceau d'électrons 11 en fonction du nombre d'onde k, s'appelle la « droite du faisceau ». La courbe II représente la relation de dispersion du réseau de diffraction 5 en deux dimensions.

Les droites III et IV correspondent respectivement à la « ligne de lumière-avant » d'équation $f = ck/2\pi$ et à la « ligne de lumière-arrière ».

Les droites III, IV et l'axe des abscisses (nombre d'onde k) délimitent un triangle appelé « triangle de la lumière ».

Si le point d'intersection entre la droite du faisceau I et la courbe représentative de la relation de dispersion du réseau 5 se situe à l'intérieur du triangle de lumière, ce qui est toujours le cas en deux dimensions, le dispositif ne peut pas émettre sur le mode fondamental. Ce dernier est alors une onde de surface évanescente dans le direction Y. Seules les harmoniques de la fréquence fondamentale peuvent alors être émises avec un faible rendement.

La courbe V représente, dans la première zone de Brillouin, la relation de dispersion en trois dimensions correspondant au mode fondamental du réseau de diffraction 5. Le point d'intersection P peut alors être en dehors du triangle de lumière ; et une émission cohérente sur le mode fondamental est alors permise car la relation (1) est satisfaite.

Dans l'exemple décrit, on choisit donc le point P comme point de fonctionnement du système faisceau-réseau. En d'autres termes, on choisit la vitesse des électrons (ou, ce qui revient au même, l'énergie cinétique de ces derniers) pour que la droite du faisceau I coupe la courbe V au point P.

D'une manière générale, dans la présente invention, on choisit la vitesse des électrons suffisamment faible pour que, dans le diagramme de dispersion (k, f) de l'ensemble réseau-faisceau, la ligne de faisceau coupe une partie d'une branche de la relation de dispersion, située dans la première zone de Brillouin et correspondant au mode fondamental du réseau de diffraction 5, en un point P situé à l'extérieur du triangle de la lumière.

Selon un mode de réalisation particulier de la présente invention, le tableau Tab1 donne les valeurs de la fréquence en GHz du point d'opération P pour un faisceau d'électrons 11 circulaire dont l'énergie cinétique est de 60 keV interagissant avec le mode fondamental du réseau de diffraction 5 équipé de ses parois latérales 51, 52, de période L en mm. Selon cet exemple, le réseau de diffraction 5 possède un profil rectangulaire des rainures et ses dimensions sont H=A=L/2 et W=2L.

[Table 1]

Tableau 1 : frequences d'opération pour KE=60 KeV, H = A = L/2 et W = 2L.

| *L* (mm) | *f*(GHz) |
|---|---|
| 0.3 | 335 |
| 0.2 | 505 |
| 0.15 | 673 |
| 0.1 | 1005 |

Grâce aux parois latérales 51, 52 situées sur les côtés du réseau de diffraction 5, il est possible d'extraire le mode fondamental du réseau 5. La moitié de l'énergie déposée par le faisceau d'électrons 11 dans le réseau de diffraction 5 est attendue sous forme de rayonnement électromagnétique dans ce mode fondamental. Pour rappel, un réseau de diffraction 5 en deux dimensions ne peut émettre du rayonnement Smith-Purcell qu'aux fréquences harmoniques de ce dernier. Dans tout système électromagnétique, les fréquences harmoniques portent toujours moins d'énergie que la fréquence fondamentale.

En outre, le faisceau d'électrons 11 continu et circulaire est choisi selon les caractéristiques suivantes :

- La densité de courant du faisceau d'électrons 11 est suffisamment élevée pour exciter fortement le mode fondamental du réseau de diffraction 5 ;
- Les électrons ont une énergie de 60 keV au niveau du réseau de diffraction ;
- Le faisceau d'électrons 11 est avantageusement mis en forme par l'intermédiaire d'une ligne de transport magnétique 13a, 13b dont le champ magnétique axial maximal peut atteindre 1.5 Tesla. Ce champ magnétique permet de maintenir le faisceau d'électrons 11 le long du réseau de diffraction 5 et d'atteindre un rayon de faisceau d'électrons compris entre 20 $\mu m$ et 50 $\mu m$ permettant ainsi d'optimiser l'interaction. Plus le champ magnétique axial au voisinage du réseau sera fort, plus le rayon d'équilibre (sans oscillations transverses le long du réseau) du faisceau sera faible.

Par exemple, en utilisant la relation de Smith-Purcell pour un réseau ayant une période L de 0,3 mm et pour une énergie cinétique des électrons de 60 keV, il en est déduit que le rayonnement est attendu à un angle au voisinage de 138° par rapport à la direction de propagation du faisceau d'électrons 11. L'énergie cinétique des électrons de 60 keV assure un bon compromis en termes de compacité, de forte valeur de gain et une puissance électrique raisonnable du faisceau d'électrons 11 pour avoir une puissance émise importante.

Ainsi, selon la présente invention, le rayonnement 3 est dirigé vers l'amont (i.e. l'arrière) du réseau de diffraction 5 (ici, le terme amont est défini par rapport au sens de propagation du faisceau d'électrons 11) selon une direction (angle $\theta$) prédéterminée.

A son tour, la forme du miroir 9 est calculée pour récupérer la majeure partie du rayonnement 3 électromagnétique et pour le rediriger parallèlement au réseau de diffraction 5 vers une sortie 15 (un hublot de sortie) en aval (i.e. à l'avant) du réseau de diffraction 5.

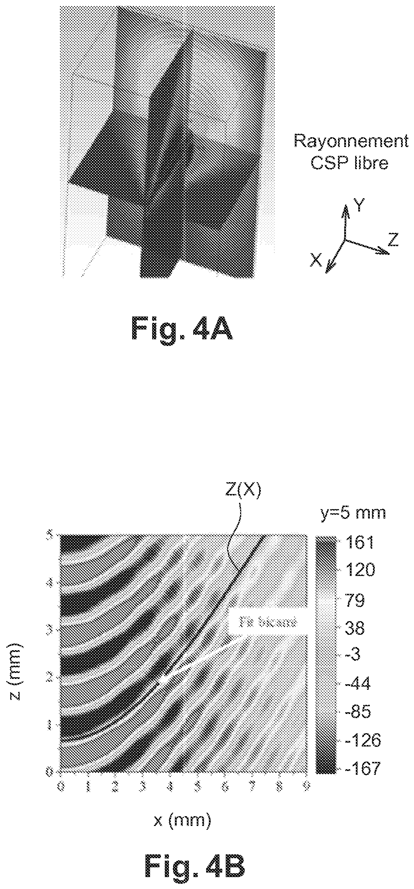

Avantageusement, le miroir 9 comporte une surface réfléchissante dont la forme géométrique est déterminée sur la base du diagramme de rayonnement « DR » complet 3D du réseau de diffraction 5 définissant les différents modes émis par ce dernier. (générant le rayonnement dans la direction $\theta$ mais également dans la direction azymutale $\varphi$). L'outil de simulation utilisé peut être un logiciel du type CST®. Le diagramme de rayonnement est décrit plus en détail en relation avec les Figs. 4A-4D.

Par ailleurs, le mode de réalisation de la Fig. 1A montre que le dispositif 1 comporte un tube 17 dont l'axe de révolution est parallèle à la propagation du faisceau d'électrons 11 (i.e. dans la direction de l'axe Z).

Le tube 17 est délimité par la source 7 des électrons sur une extrémité et par un hublot de sortie 15 sur l'autre extrémité. Ainsi, le tube 17 pourvu de la source 7 et du hublot de sortie 15 forment une enceinte à vide à l'intérieur de laquelle la pression est de l'ordre de $10^{-8}$ mbar à $10^{-7}$ mbar (avec $10^5$ Pa = 1 bar=1000 mbar). De préférence, le tube cylindrique 17 est en métal amagnétique.

En outre, le dispositif 1 comporte un support 19, disposé à l'intérieur du tube 17 entre la source 7 et le hublot de sortie 15, sur lequel sont fixés (au moyens de vis20 et/ou de goupilles 22) de manière amovible sur l'axe Z le réseau de diffraction 5 et le miroir 9. De préférence, le support 19 est amagnétiques. Avantageusement, le support 19 est résistant à plus de 300°C.

Selon un mode de réalisation particulier de la présente invention, le support 19 comporte une première partie 19a dans le plan (X, Y) de surface circulaire perpendiculaire à l'axe du tube 17 (i.e. l'axe Z). Cette première partie 19a du support est pourvu d'un orifice circulaire 21 pour laisser passer le faisceau d'électrons 11. Le miroir 9 est fixé sur cette partie circulaire 19a du support.

Le support 19 comporte une deuxième partie 19b dans le plan (X, Z) de surface rectangulaire parallèle à l'axe Z du tube 17. Le réseau de diffraction 5 est fixé sur cette partie rectangulaire 19b du support de sorte que le faisceau d'électrons passant par le trou 21 puisse se propager en incidence rasante le long du réseau 5. L'espace entre la partie circulaire 19a du support et le hublot de sortie 15 forme la chambre de propagation 25.

En outre, le dispositif 1 comporte un élément d'arrêt 23 du faisceau fixé sur la partie rectangulaire 19b du support 19 situé en aval du réseau de diffraction 5. L'élément d'arrêt 23 du faisceau est destiné à absorber le faisceau d'électrons 11 en aval du réseau de diffraction 5.

Avantageusement, l'élément d'arrêt 23 du faisceau présente une forme géométrique configurée pour répartir la collection des électrons sur la plus grande surface possible afin de minimiser la densité de courant du faisceau d'électrons 11 sur l'élément d'arrêt, sans obstruer le passage du rayonnement 3 qui peut alors passer par le hublot de sortie 15. Avantageusement, l'élément d'arrêt 23 du faisceau est en graphite.

Le support 19 ainsi que le miroir 9, le réseau de diffraction 5, et l'élément d'arrêt 23 forment un module 27 de propagation THz disposé dans la chambre de propagation 25. Le module 27 de propagation THz selon la présente invention est très compact, sa longueur n'excède pas quelques dizaines de mm s'intégrant dans un tube 17 sous vide d'un diamètre n'excédant pas 20 mm,

Ainsi, le miroir 9 et le réseau de diffraction 5 sont interchangeables sur le support 19 dans le but de modifier la fréquence d'émission du rayonnement 3 électromagnétique en fonction des paramètres désirés par l'opérateur.

Avantageusement, le dispositif 1 comporte des éléments de focalisation 13a et de guidage 13b (par exemple, une ligne de transport magnétique) disposés à l'extérieur du tube 17. Ces éléments 13a, 13b sont configurés pour focaliser, guider et maintenir le faisceau d'électrons 11 dans la zone située au-dessus du réseau de diffraction 5.

La Fig. 3 représente de manière schématique le module de propagation THz du dispositif illustrant l'interchangeabilité de ces éléments amovibles, selon un mode de réalisation de l'invention.

La mise en œuvre du processus de changement du réseau de diffraction 5 et/ou du miroir 7 est relativement simple et rapide. Les étapes permettant de changer la fréquence d'émission du dispositif 1 est le suivant :

1. Fermeture d'une vanne d'isolement (non représentée) située entre le canon 7 à électrons et la chambre de propagation 25 sous vide contenant le module 27 de propagation THz. Nous noterons que le canon 7 à électrons reste constamment sous vide ;
2. Mise à l'air du tube sous vide et ouverture de la chambre de propagation 25 en enlevant le hublot de sortie 15 ;
3. Extraction du module 27 de propagation THz à l'aide d'une goupille d'arrêt autobloquante s'insérant dans le support 19 ;
4. Démontage des vis 20 de serrage du réseau 5 et/ou du miroir 9 ;
5. Montage du nouveau réseau 5 et/ou du miroir 9 ;
6. Mise en place du nouveau module 27 de propagation THz dans la chambre de propagation 25 à l'aide de la goupille ;
7. Fermeture de la chambre de propagation 25 en remettant le hublot de sortie 15
8. Mise sous vide ($10^{-7}$ mbar - $10^{-8}$ mBar) et ouverture de la vanne d'isolement.

On notera que le miroir 9 s'insère à l'intérieur du tube 17 sous vide dans un espace réduit au-dessus du réseau 5. Comme indiqué précédemment, dans le but de renvoyer l'ensemble de la puissance émise vers la sortie du dispositif 1, on dimensionne le miroir 9 sur la base du diagramme de rayonnement « DR » complet du réseau 5 générant le rayonnement dans la direction $\theta$ mais également dans la direction $\varphi$ (coordonnée sphériques).

En effet, les Figs. 4A-4D illustrent le dimensionnement du miroir selon le diagramme de rayonnement, selon un mode de réalisation de l'invention.

Plus particulièrement, la Fig. 4A représente un diagramme de rayonnement calculé pour un réseau de diffraction d'une période L de 0,3 mm, selon un mode de réalisation de l'invention.

Le diagramme de rayonnement, observable en traçant à différents intervalles de temps, les valeurs de la composante axiale du vecteur de Poynting (densité de puissance émise) dans tout l'espace. Après un temps t > 1ns, le diagramme de rayonnement garde la même forme avec seulement des variations locales dans l'intensité du champ. L'émission à l'angle de Smith-Purcell (138° pour un réseau d'une période L de 0,3 mm) est visible dans le plan de coupe YOZ mais une grande partie de l'émission s'étend dans la direction $\varphi$.

Dans un second temps, la forme du miroir 5 est déterminée en utilisant les principes de l'optique géométrique. Elle est basée sur l'étude du diagramme de rayonnement du réseau seul dans l'espace et est obtenue à l'aide de CST®. Plutôt que de travailler sur le vecteur de Poynting, on peut travailler avec les contours de la composante $B_x$ du champ magnétique (suivant la direction X ) qui est plus adaptée pour observer le front des ondes issues du réseau de diffraction 5. Comme indiqué précédemment, l'angle d'émission dans le plan YOZ est l'angle Smith-Purcell de 138°. En revanche, dans les plans (X, Z), les angles sont un peu plus complexes à estimer.

La Fig. 4B représente justement le rayonnement dans un plan (X, Z) du diagramme de la Fig. 4A. Ce genre de diagramme permet de déterminer les angles dans les plans (X, Z) pour différentes valeurs de Y.

En particulier, la Fig. 4B est un exemple représentant le contour $B_x$ dans le plan Y= 5 mm. En connaissant la coordonnée Z de la position où le miroir 5 peut être mécaniquement placé, on peut faire correspondre « fitter » le contour Z(X) que doit avoir le miroir à cet endroit pour intercepter les rayons issus du réseau et les renvoyer parallèlement à l'axe Z.

La Fig. 4C illustre de manière schématique la construction de la surface du miroir, selon un mode de réalisation de l'invention.

L'utilisation d'un polynôme bicarré est suffisant pour restituer la courbure du miroir à toute position verticale Y. Connaissant la courbe de front d'onde dans ce plan sous forme de polynôme, on peut tracer en chaque point $x_0$ de cette courbe deux droites correspondant à la normale et la tangente. La normale en $x_0$ correspond à un rayon lumineux issu du réseau de diffraction 5 qui devra être renvoyé vers l'avant parallèlement à l'axe OZ. La tangente en $x_0$ est utilisée pour déterminer un point sur la nouvelle courbe $Z(x_M)$ qui permettra de décrire la forme du miroir 5 dans le plan Y considéré. Connaissant l'angle du rayon par rapport à l'axe OZ, on calcule l'angle que doit avoir la normale au point intercepté par le rayon de la nouvelle courbe pour renvoyer le rayon vers l'avant.

On réitère ensuite cette méthode pour différentes valeurs de Y. Pour le miroir 5 à une fréquence de 335 GHz, on a choisi huit plans (X, Z) pour Y variant de 2 à 9 mm par pas de 1 mm. Sont obtenues ensuite huit courbes dont les coefficients polynomiaux varient avec Y et peuvent être de nouveau fittés pour obtenir l'équation de la surface du miroir 5. A titre d'exemple, l'ensemble des calculs et la construction de la surface du miroir 5 peut être réalisé sous le logiciel Maple[R].

La Fig. 4D représente un exemple d'un fichier de points déterminés selon la méthode expliquée ci-dessus en relation avec la Fig. 4C pour un réseau d'une période L de 0,3 mm.

Ainsi, la présente invention propose un dispositif permettant d'atteindre des niveaux de puissance relativement importants allant de quelques dizaines de watt à 100 GHz jusqu'au Watt à 1 THz tout en étant très compacte, n'excédant pas une longueur d'une cinquantaine de mm pour un diamètre d'une vingtaine de mm.

**Revendications**

**1.** Dispositif (1) de production de rayonnement électromagnétique Smith-Purcell cohérent comprenant :

- un réseau de diffraction (5) électriquement conducteur, délimité latéralement par deux parois latérales externes (51, 52) électriquement conductrices ;
- une source (7) pour émettre un faisceau d'électrons (11) et le propager au-dessus du réseau de diffraction (5), le faisceau d'électrons étant configuré pour interagir avec le réseau de diffraction de manière à engendrer un rayonnement (3) électromagnétique de Smith-Purcell cohérent dirigé vers l'amont du réseau de diffraction (5) selon une direction prédéterminée ; et

un miroir (9) configuré pour récupérer la plus grande partie du rayonnement électromagnétique et pour le rediriger parallèlement au réseau de diffraction (5) vers une sortie (15) en aval du réseau de diffraction (5), ledit miroir (9) comportant une surface réfléchissante dont la forme géométrique est déterminée sur la base d'un diagramme de rayonnement du réseau de diffraction (5) définissant les différents modes émis par ce dernier.

2. Dispositif selon la revendication 1, tel que les caractéristiques du faisceau d'électrons incluent :

- une vitesse des électrons suffisamment faible pour que, dans un diagramme de dispersion, où l'on exprime la fréquence (f) en fonction du nombre d'onde (k), une droite (I) représentant la fréquence du faisceau d'électrons en fonction de son nombre d'onde, et une courbe (V) représentant, dans la première zone de Brillouin, la relation de dispersion en trois dimensions correspondant au mode fondamental du réseau de diffraction (5), se croisent en un point (P) situé à l'extérieur d'un triangle isocèle dont la base est confondue avec l'axe des abscisses du diagramme de dispersion et dont un côté (III) est un segment de pente $c/2\pi$ passant par l'origine dudit diagramme, où c est la célérité de la lumière dans le vide ; et
- une densité de courant suffisamment élevée pour exciter le mode fondamental du réseau de diffraction (5).

3. Dispositif selon la revendication 1 ou 2, comportant :

- un tube (17) dont l'axe est parallèle à la propagation du faisceau d'électrons (11), ledit tube étant pourvu de la source (7) sur une extrémité et d'un hublot de sortie (15) sur l'autre extrémité, et
- un support (19) disposé à l'intérieur du tube entre la source (7) et le hublot de sortie (15) et sur lequel sont fixés de manière amovible le réseau de diffraction (5) et le miroir (9).

4. Dispositif selon la revendication 3, tel que le support (19) comporte une première partie (19a) de surface circulaire perpendiculaire à l'axe du tube (17) et pourvu d'un orifice circulaire (21) pour laisser passer le faisceau d'électrons (11) et une deuxième partie (19b) de surface rectangulaire parallèle à l'axe du tube, le miroir (9) étant fixé sur la partie circulaire du support tandis que le réseau de diffraction (5) est fixé sur la partie rectangulaire du support.

5. Dispositif selon la revendication 4, comportant un élément d'arrêt (23) du faisceau fixé sur la partie (19b) rectangulaire du support en aval du réseau de diffraction (5), ledit élément d'arrêt du faisceau étant destiné à absorber le faisceau en aval du réseau.

6. Dispositif selon la revendication 5, tel que l'élément d'arrêt (23) du faisceau présente une forme géométrique configurée pour faire répartir la densité de courant du faisceau d'électrons sur le maximum de surface tout en laissant passer le rayonnement électromagnétique par le hublot de sortie (15).

7. Dispositif selon l'une quelconque des revendications 3 à 6, tel que le tube pourvu de la source (7) et du hublot de sortie (15) forment une enceinte à vide à l'intérieur de laquelle la pression est de l'ordre de $10^{-8}$ mbar à $10^{-7}$ mbar.

8. Dispositif selon l'une quelconque des revendications précédentes, comportant des éléments de focalisation et de guidage configurés pour focaliser, guider et maintenir le faisceau d'électrons (11) dans une zone située au-dessus du réseau de diffraction (5).

9. Procédé de production de rayonnement électromagnétique Smith-Purcell cohérent dans lequel :

- on utilise un réseau de diffraction (5) électriquement conducteur, délimité latéralement par deux parois latérales externes (51, 52) électriquement conductrices ;
- on propage un faisceau d'électrons (11) au-dessus du réseau de diffraction (5), le faisceau d'électrons étant configuré pour interagir avec le réseau de diffraction de manière à engendrer un rayonnement (3) électromagnétique de Smith-Purcell cohérent dirigé vers l'amont du réseau de diffraction (5) selon une direction prédéterminée ; et
- on utilise un miroir (9) configuré pour récupérer l'ensemble du rayonnement électromagnétique et pour le rediriger parallèlement au réseau de diffraction (5) vers une sortie (15) en aval du réseau de diffraction (5), ledit miroir (9) comportant une surface réfléchissante dont la forme géométrique est déterminée sur la base d'un diagramme de rayonnement du réseau de diffraction (5) définissant les différents modes émis par ce dernier.

**Patentansprüche**

1. Kohärente Smith-Purcell-Vorrichtung (1) zur Erzeugung elektromagnetischer Strahlung, umfassend:

- ein elektrisch leitfähiges Beugungsnetzwerk (5), das seitlich durch zwei elektrisch leitfähige äußere Seitenwände (51, 52) begrenzt ist;
- eine Quelle (7) zum Aussenden eines Elektronenstrahls (11) und dessen Ausbreiten über das Beugungsnetzwerk (5), wobei der Elektronenstrahl so eingerichtet ist, dass er mit dem Beugungsnetzwerk interagiert, um eine kohärente elektromagnetische Strahlung (3) von Smith-Purcell zu erzeugen, die in einer vorbestimmten Richtung stromaufwärts des Beugungsnetzwerks (5) gerichtet ist; und

einen Spiegel (9), der so eingerichtet ist, dass er den größten Teil der elektromagnetischen Strahlung aufnimmt und sie parallel zu dem Beugungsnetzwerk (5) zu einem Ausgang (15) nach dem Beugungsnetzwerk (5) umleitet, wobei der Spiegel (9) eine reflektierende Oberfläche aufweist, deren geometrische Form auf der Grundlage eines Strahlungsdiagramms des Beugungsnetzwerkes (5) bestimmt wird, das die verschiedenen von diesem emittierten Modi definiert.

2. Vorrichtung nach Anspruch 1, wobei die Merkmale des Elektronenstrahls Folgendes enthalten:

- eine Elektronengeschwindigkeit, die so gering ist, dass in einem Streudiagramm, in dem die Frequenz (f) als Funktion der Wellenzahl (k) ausgedrückt wird, eine Gerade (I), die die Frequenz des Elektronenstrahls als Funktion seiner Wellenzahl darstellt, und eine Kurve (V), die in der ersten Brillouin-Zone die dreidimensionale Streuungsbeziehung darstellt, die dem grundlegenden Modus des Beugungsnetzwerkes (5) entspricht, sich an einem Punkt (P) kreuzen, der sich außerhalb eines gleichschenkligen Dreiecks befindet, dessen Basis mit der X-Achse des Streudiagramms zusammenfällt und dessen eine Seite (III) ein Segment mit der Steigung $c/2\pi$ ist, das durch den Ursprung des Diagramms verläuft, wobei c die Lichtgeschwindigkeit in dem Vakuum ist; und
- eine ausreichend hohe Stromdichte, um den Grundmodus des Beugungsnetzwerkes (5) anzuregen.

3. Vorrichtung nach Anspruch 1 oder 2, die Folgendes aufweist:

- ein Rohr (17), dessen Achse parallel zur Ausbreitung des Elektronenstrahls (11) ist, wobei das Rohr an einem Ende mit der Quelle (7) und an dem anderen Ende mit einem Ausgangsfenster (15) versehen ist, und
- einen Halter (19), der innerhalb des Rohrs zwischen der Quelle (7) und dem Ausgangsfenster (15) angeordnet ist und an dem das Beugungsnetzwerk (5) und der Spiegel (9) abnehmbar befestigt sind.

4. Vorrichtung nach Anspruch 3, wobei der Halter (19) einen ersten Teil (19a) mit einer kreisförmigen Oberfläche senkrecht zu der Rohrachse (17) und mit einer kreisförmigen Öffnung (21) zum Durchlassen des Elektronenstrahls (11) und einen zweiten Teil (19b) mit einer rechteckigen Oberfläche parallel zur Rohrachse aufweist, wobei der Spiegel (9) an dem kreisförmigen Teil des Halters befestigt ist, während das Beugungsnetzwerk (5) an dem rechteckigen Teil des Halters befestigt ist.

5. Vorrichtung nach Anspruch 4, die ein Strahlstoppelement (23) aufweist, das an dem rechteckigen Teil (19b) des Trägers stromabwärts des Beugungsnetzwerkes (5) befestigt ist, wobei das Strahlstoppelement dazu bestimmt ist, den Strahl stromabwärts des Netzwerkes aufzunehmen.

6. Vorrichtung nach Anspruch 5, wobei das Strahlstoppelement (23) eine geometrische Form besitzt, die so eingerichtet ist, dass sie die Stromdichte des Elektronenstrahls auf das Maximum der Oberfläche verteilt, während sie gleichzeitig die elektromagnetische Strahlung durch das Ausgangsfenster (15) passieren lässt.

7. Vorrichtung nach einem der Ansprüche 3 bis 6, wobei das Rohr, das mit der Quelle (7) und dem Ausgangsfenster (15) versehen ist, eine Vakuumkammer bildet, in der der Druck im Bereich von $10^{-8}$ mbar bis $10^{-7}$ mbar liegt.

8. Vorrichtung nach einem der vorhergehenden Ansprüche, die Fokussier- und Führungselemente aufweist, die so eingerichtet sind, dass sie den Elektronenstrahl (11) in einem Bereich oberhalb des Beugungsnetzwerkes (5) fokussieren, führen und halten.

9. Kohärentes Smith-Purcell-Verfahren zur Erzeugung elektromagnetischer Strahlung, bei dem:

- ein elektrisch leitfähiges Beugungsnetzwerk (5) verwendet wird, das seitlich durch zwei elektrisch leitfähige äußere Seitenwände (51, 52) begrenzt ist;
- ein Elektronenstrahl (11) über das Beugungsnetzwerk (5) ausgebreitet wird, wobei der Elektronenstrahl so eingerichtet ist, dass er mit dem Beugungsnetzwerk interagiert, um eine kohärente elektromagnetische Strahlung (3) von Smith-Purcell zu erzeugen, die in einer vorbestimmten Richtung stromaufwärts des Beugungsnetzwerks (5) gerichtet ist; und
- ein Spiegel (9) verwendet wird, der so eingerichtet ist, dass er die gesamte elektromagnetische Strahlung aufnimmt und sie parallel zu dem Beugungsnetzwerk (5) zu einem Ausgang (15) nach dem Beugungsnetzwerk (5) umleitet, wobei der Spiegel (9) eine reflektierende Oberfläche aufweist, deren geometrische Form auf der Grundlage eines Strahlungsdiagramms des Beugungsnetzwerkes (5) bestimmt wird, das die verschiedenen von diesem ausgestrahlten Modi definiert.

**Claims**

1. A device (1) for producing coherent Smith-Purcell electromagnetic radiation comprising:

   - an electrically conductive diffraction grating (5), laterally defined by two electrically conductive outer side walls (51, 52);
   - a source (7) for emitting an electron beam (11) and propagating it above the diffraction grating (5), the electron beam being configured to interact with the diffraction grating so as to generate coherent Smith-Purcell electromagnetic radiation (3) directed upstream of the diffraction grating (5) in a predetermined direction; and

   a mirror (9) configured to collect the majority of the electromagnetic radiation and redirect it parallel to the diffraction grating (5) to an exit (15) downstream of the diffraction grating (5), said mirror (9) comprising a reflective surface, the geometric shape of which is determined based on a radiation diagram of the diffraction grating (5) defining the different modes emitted by the latter.

2. The device according to claim 1, such that the features of the electron beam include:

   - a sufficiently low electron velocity so that, in a scatter diagram, where the frequency (f) is expressed according to the wave number (k), a line (I) representing the frequency of the electron beam according to its wave number, and a curve (V) representing, in the first Brillouin zone, the three-dimensional scatter relationship corresponding to the fundamental mode of the diffraction grating (5), intersect at a point (P) located outside an isosceles triangle, the base of which is coincident with the x-axis of the scatter diagram and one side (III) of which is a slope segment $c/2\pi$ passing through the origin of said diagram, where c is the speed of light in vacuum; and
   - a sufficiently high current density to excite the fundamental mode of the diffraction grating (5).

3. The device according to claim 1 or 2, comprising:

   - a tube (17), the axis of which is parallel to the propagation of the electron beam (11), said tube being provided with the source (7) at one end and an exit port (15) at the other end, and
   - a support (19) disposed inside the tube between the source (7) and the exit port (15) and on which the diffraction grating (5) and the mirror (9) are removably fastened.

4. The device according to claim 3, such that the support (19) comprises a first part (19a) with a circular surface perpendicular to the axis of the tube (17) and provided with a circular orifice (21) to allow the electron beam (11) through and a second part (19b) with a rectangular surface parallel to the axis of the tube, the mirror (9) being fastened to the circular part of the support whereas the diffraction grating (5) is fastened to the rectangular part of the support.

5. The device according to claim 4, comprising a beam stop element (23) fastened to the rectangular part (19b) of the support downstream of the diffraction grating (5), said beam stop element being intended to absorb the beam downstream of the grating.

6. The device according to claim 5, such that the beam stop element (23) has a geometric shape configured to distribute the current density of the electron beam over the maximum surface area while allowing the electromagnetic radiation through the exit port (15).

7. The device according to any one of claims 3 to 6, such that the tube provided with the source (7) and the outlet port (15) form a vacuum chamber within which the pressure is in the order of $10^{-8}$ mbar to $10^{-7}$ mbar.

8. The device according to any one of the preceding claims, comprising focusing and guiding elements configured to focus, guide and hold the electron beam (11) in a zone located above the diffraction grating (5).

9. A method for producing coherent Smith-Purcell electromagnetic radiation wherein:

- an electrically conductive diffraction grating (5), laterally defined by two electrically conductive outer side walls (51, 52), is used;
- an electron beam (11) is propagated above the diffraction grating (5), the electron beam being configured to interact with the diffraction grating so as to generate coherent Smith-Purcell electromagnetic radiation (3) directed upstream of the diffraction grating (5) in a predetermined direction; and
- a mirror (9) configured to collect all of the electromagnetic radiation and redirect it parallel to the diffraction grating (5) to an exit (15) downstream of the diffraction grating (5) is used, said mirror (9) comprising a reflective surface, the geometric shape of which is determined based on a radiation diagram of the diffraction grating (5) defining the different modes emitted by the latter.

**Fig. 1A**

**Fig. 1B**

**Fig. 2**

**Fig. 3**

Rayonnement
CSP libre

**Fig. 4A**

**Fig. 4B**

**Fig. 4C**

Surface calculé du miroir

**Fig. 4D**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3004294

- FR 2980923

**Littérature non-brevet citée dans la description**

- **T. DONOHUE** ; **J. GARDELLE**. Simulation of a Smith-Purcell free-electron laser with sidewalls : Copious emission at the fundamental frequency. *AppliedPhysics Letters*, 2011, vol. 99, 161112-1
- **GARDELLE J et al.** Observation of copious emission at the fundamental frequency by a Smith-Purcell free-electron laser with sidewalls. *APPLIED PHYSICS LETTERS*, 26 March 2012, vol. 100 (13), 131103-131103

- **DONOHUE J T et al.** INTENSE EMISSION OF SMITH-PURCELL RADIATION AT THE FUNDAMENTAL FREQUENCY FROM A GRATING EQUIPPED WITH SIDEWALLS. *Proceedings of FEL2013, New York, NY, USA, WEOBNO03*, 2013, 477-480
- **GARDELLE J et al.** Observation of coherent Smith-Purcell radiation using an initially continuous flat beam. *PHYSICAL REVIEW SPECIAL TOPICS - ACCELERATORS AND BEAMS*, 01 November 2009, vol. 12 (11)